# EUROPEAN PATENT SPECIFICATION

(11) **EP 2 200 096 B1**
(45) Date of publication and mention of the grant of the patent: **18.09.2019**
(21) Application number: 08305969.1
(22) Date of filing: 18.12.2008
(51) Int. Cl.: H01L 31/107, H01L 31/0304

(54) **Avalanche photodiode**
Lawinenphotodiode
Photodiode à effet d'avalanche

(43) Date of publication of application: 23.06.2010
(73) Proprietor: Alcatel Lucent, 91620 Nozay (FR); THALES, 92200 Neuilly-sur-Seine (FR)
(72) Inventor: Achouche, Mohand, 91460, Marcoussis (FR)
(74) Representative: Nokia EPO representatives

(56) References cited:
- US-A- 5 369 292
- US-A- 5 539 221
- US-A- 5 654 578
- US-A1- 2007 152 289
- KIM GYUNGOCK ET AL: "Enhanced frequency response associated with negative photoconductance in an InGaAs/InAlAs avalanche photodetector" APPLIED PHYSICS LETTERS, AIP, AMERICAN INSTITUTE OF PHYSICS, MELVILLE, NY, US, vol. 83, no. 6, 11 August 2003 (2003-08-11), pages 1249-1251, XP012035775 ISSN: 0003-6951
- TSUJI M ET AL: "INALGAAS STAIRCASE AVALANCHE PHOTODIODES GROWN BY METAL-ORGANIC VAPOR PHASE EPITAXY" PROCEEDINGS OF THE EUROPEAN CONFERENCE ON OPTICAL COMMUNICATION (ECOC) MONTREUX, SEPT. 12 - 16, 1993. REGULAR PAPERS; [PROCEEDINGS OF THE EUROPEAN CONFERENCE ON OPTICAL COMMUNICATION (ECOC)], ZURICH, SEV, CH, vol. 2, 12 September 1993 (1993-09-12), pages 389-392, XP000492244

## Description

The present invention relates to avalanche photodiodes.

### BACKGROUND ART

Avalanche photodiodes (APD) are widely used as components for many applications in telecommunication such as fiber optics transmission systems, free-space optics communication, as well as for other optical applications such as height resolution, ranging, sensing, spectroscopy and the like, due to the fact that their internal gain improves considerably the sensitivity of photoreceivers for the particular application. Currently, APDs are used for increasing the power budget for channel data rates below 10 Gb/s. However, it is considered to be very likely that similar paths are followed with the deployment of high speed networks with data rates at or above 10 Gb/s, which presently operate using pin receivers. Indeed the expected significant improvement in sensitivity, expected to reach as far as about 10 dB, may allow for replacing expensive gain block units such as erbium-doped fiber amplifiers (EDFAs) by APDs; or in some case, for example at a rate of about 40 Gb/s, to introduce new optical processing elements such as dispersion compensating modules in 40 Gb/s transponders.

For high bit rate applications such as 40 Gb/s, some important issues to be taken into consideration in order to achieve high sensitivity avalanche photodiodes are a high level of responsivity, a wide bandwidth at low multiplication gain and an optimum gain-bandwidth product.

In order to achieve such objectives, one known solution employed in the recent years is the use of lateral-illumination for APDs because it allows for reducing the thickness of the absorption layer so as to reduce transit time without compromising the responsivity. This leads to improved bandwidth at low gains compared to conventional surface-illuminated APDs. However, this type of APDs also suffer from limitations in design in order to achieve wide bandwidth at low multiplication gains and high gain-bandwidth product.

One such limitation is related to device size. While these devices allow for further reduction of device active area in order to improve limitation in bandwidth caused by the RC filtering effect in the device (in general, the bandwidth depends on photogenerated carriers transit time and RC-low pass filter), such reduction of device size however degrades device responsivity due to a corresponding reduction of the absorption area and volume.

Another limitation of such devices is related to the gain-bandwidth product. In principle, it should be possible to improve the gain-bandwidth product by reducing the thickness of the multiplication layer (including the thickness of the transition layer). However, an excessively thin transition layer (composed of a grading layer and a charge layer) gives rise to the production of unwanted multiplication in the absorption region.

On the other hand, in order to achieve high multiplication gains, a thick avalanche layer is needed so as to support an electric field which is sufficiently high in order to produce high ionization of photogenerated carriers (carriers acquiring high energy) without excessive dark current.

### SUMMARY OF THE INVENTION

Embodiments of invention feature a single carrier avalanche photodiode comprising a p-doped absorption layer, an unintentionally doped avalanche multiplication layer and an n-doped collector layer, the collector layer being capable of collecting electrons injected from the avalanche layer.

US 5,369,292 relates to an avalanche photodiode in which a strained superlattice structure is used as a multiplication layer, comprising: an n⁺ type InP substrate; an n⁺ InP epitaxial layer formed on a main surface of the substrate; an N type In₁₋ₓAlₓAs layer formed on the epitaxial layer; an n⁺ type In₁₋ₓAlₓAs layer formed on the N type In₁₋ₓAlₓAs layer, the n⁺ type In₁₋ₓAlₓAs layer having a relatively high impurity concentration more than the N type In₁₋ₓAlₓAs layer; the multiplication layer deposited on the n⁺ type In₁₋ₓAlₓAs layer, the multiplication layer having an In_{0.53}Ga_{0.47}AS/In₁₋ₓAlₓAs superlattice structure; first and second p⁺ type In₁₋ₓAlₓAs layers laminated sequentially on the multiplication layer; an absorbing layer formed on the second p⁺ type In₁₋ₓAlₓAs layer, the absorbing layer being made of an In_{0.53}Ga_{0.47}As; a P type InP layer formed on the absorbing layer to reduce a surface leakage current; an In_{0.53}Ga_{0.47}As layer formed on the P type InP layer to be provided for an ohmic contact, and metal layers formed on an upper surface of the In_{0.53}Ga_{0.47}As layer and the other surface of the substrate, respectively. US 5,654,578 and US 2007 152289 A1 relate to avalanche photodiodes having a graded absorption layer and an undoped multiplication layer.

The invention is defined by the independent claims 1 and 6.

Further advantageous embodiments of the invention are the subject of the dependent claims.

### BRIEF DESCRIPTION OF THE DRAWINGS

Figure 1 is a schematic representation of a structure of a conventional avalanche photodiode.
Figure 2 is a schematic representation of a structure of an avalanche photodiode according to embodiments of the invention.

### DETAILED DESCRIPTION OF EMBODIMENTS

For a better understanding of the structure of the APD proposed herein, reference is first made to some known structures of APDs.

A first example is an APD structure comprising an avalanche layer made of a bulk AlInAs material or an AlInAs/AlGaInAs MQW (Multiple Quantum Well) and an absorption layer of GalnAs material. The bulk multiplication layer is made thin enough so as to allow for a large ionization coefficient ratio k by reduced fluctuation in multiplication events, where k= α/β, α and β being the ionization coefficients of electrons and holes respectively. This results in reducing excess noise and enhances gain-bandwidth product. Using a waveguide for lateral-illumination and very thin absorption (about 0.5 µm) and multiplication (about 0.1 µm) layers, an APD has demonstrated a 3-dB bandwidth of 30 GHz at low gains and a limited gain-bandwidth product of 140 GHz. This is not a satisfactory result because for high speed operations at 40Gb/s, this low gain-bandwidth product limits the avalanche gain to M=3-4 which is not desirable.

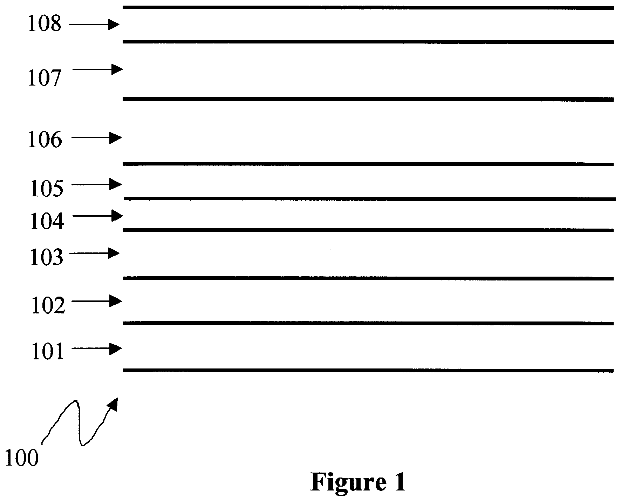

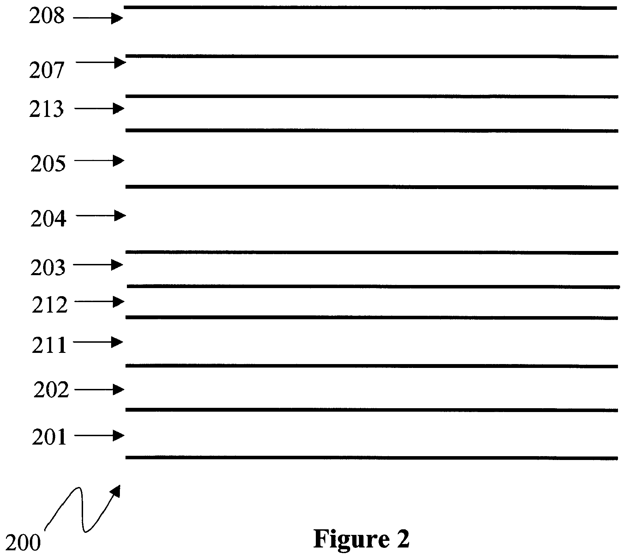

It is further to be noted that both figures 1 and 2 represent only schematic and simplified illustrations of layers of avalanche photodiode structures. These figures are therefore not in scale.

Reference is now made to figure 1 with the aim of briefly describing the structure of a conventional APD in which only those elements which are relevant for the present discussion are represented.

Figure 1 schematically represents a structure of a conventional APD 100 comprising a substrate 101 typically of InP, an N contact layer 102 typically of N-doped material, the material being for example InAIAs, an avalanche layer 103 typically of undoped InAlAs material, a charge layer 104 typically of P-doped InAIAs material, a grading layer 105 of unintentionally doped InGaAIAs material, an absorption layer 106 of undoped InGaAs material, a window layer 107 of P-doped InP material and a P contact layer 108 of InGaAs material. It is to be noted that the above materials are only provided in an exemplary manner and those skilled in the art realize that other materials are also usable in the construction of a conventional APD.

The characteristics of the above mentioned layers are generally known to a person skilled in the related art. In brief, an absorption layer is capable of absorbing photons from an incident light so as to generate electron/hole pairs which travel into the avalanche multiplication layer. In the avalanche multiplication layer the electrons and holes are multiplied by the avalanche effect. The grading layer provides a smooth transition of the generated carriers from the absorption layer to the avalanche multiplication layer. The charge layer contributes in providing a high electric field in the avalanche multiplication layer while the electric field in the absorption layer is maintained a low in order to avoid tunneling effect. The P and N contact layers provide contacting possibility with the bias voltage which is intended to be applied on the device structure in order to provide the required electric field.

The layers are formed according to known methods such as for example epitaxial growth.

Figure 2 schematically represents a structure of an APD 200 according to some embodiments of the present inventions. The APD 200 structure comprises a substrate 201 of InP, an N contact layer 202 of N-doped material for example GaInAsP (InAIAs may also be used as an alternative material, however GalnAsP is preferred because the collector layer uses a similar material, GalnAsP), an avalanche layer 203 of undoped InAIAs material, a charge layer 204 of P-doped InAIAs material, a grading layer 205 of unintentionally doped InGaAIAs material, an absorption layer 213 as will be described in further detail below, a window layer 207 of P-doped InP material and a P contact layer 208 of p-doped InGaAs material. It is to be noted that the above materials are only provided in an exemplary manner and those skilled in the art realize that other materials are also usable in the construction of a conventional APD.

According to embodiments of the invention, the APD further comprises at least two drift regions (instead of one in conventional APDs). A first region, similar to conventional APDs, is the avalanche multiplication layer 203. This level however is preferably unintentionally doped AllnAs that provides internal gain in the photodiode by impact ionization process. A second region is a collector layer 211 which is in charge of reducing capacitance in the device. The collector layer 211 is preferably of n- doped (Ga)In(As)P material which collects injected electrons from the avalanche layer. The doping level of the n-doped collector layer is preferably in the order of about 1x10¹⁶cm⁻³ and having a preferred thickness of about 0.2µm.

Preferably, a built-in field layer 212 of n+ doped material is provided between avalanche multiplication layer 203 and the collector layer 211 in order to improve the injection of electrons in the collector layer 211. The built-in field layer 212 is preferably made very thin, namely of a thickness in the order of about 0.03µm to about 0.07 µm, and preferably about 0.05µm. The n+ doped material of the built-in field is preferably AlInAs being highly doped, namely in order of about 7x10¹⁸cm⁻³ or higher.

In addition according to embodiments of the present invention, the light absorption layer 213 of the APD 200 is slightly p-doped (as opposed to the undoped absorption layer comprised in a conventional APD 100). The p-doped light absorption layer 213 is for example of GaInAs material, being doped at a level of about 5x10¹⁷ cm⁻³ or comprises a gradual p-doping level which varies between 5x10¹⁷ cm⁻³ and 2x10¹⁸ cm⁻³.

Alternatively, the p-doped absorption layer may be of GaAsSb material typically used for detection of a 1.55µm wavelength, the level of doping being approximately similar to the GaInAs material.

The fact that the absorption layer 213 is doped at such levels allows the photodiode to operate as a single carrier device. This is because when the APD is biased the photogenerated majority holes inside the absorption layer 213 diffuse to the p-contact layer 208 and thus have a relatively fast response within the dielectric relaxation time. The P contact layer 208 acts as a diffusion block layer because of the existence of a wide bandgap and the voltage applied, thereby forcing the diffusion of electrons toward the avalanche layer 203 where they experience the avalanche multiplication under the electric field applied to the device. As a consequence, the device operates substantially as a single carrier device that uses substantially only electrons as active carriers. Therefore total delay time of the device is related to (or dependent on) only electrons because secondary holes generated by impact ionization process are collected in the adjacent absorption layer (which is slightly p-doped).

With the use of a single carrier avalanche photodiode substantially only photo-excited electrons are used as active carriers in the pin-structure.

As mentioned above, the p-contact layer 208 acts as a diffusion block layer that causes a unidirectional motion in the electrons so as to move them toward the avalanche multiplication layer 203, thus contributing to a pure electron injection avalanche structure thereby improving noise and gain-bandwidth product. This is due to reduced delay time and single carrier type injection which is, as is known, contributes to improve both noise figure and gain-bandwidth product.

Secondary holes which may be generated by the avalanche multiplication process would present a reduced transit time compared to secondary holes produced in conventional APD structures, because in the new APD structure according to the invention these holes are not caused to drift inside the p-doped absorption layer 213 as they are majority carriers in the latter layer.

On the other hand, the presence of a collector layer 211 between the avalanche layer 203 and the n-doped contact layer 202 in the single carrier APD proposed herein, contributes to an efficient transfer of electrons to the n-doped contact layer 202 and reduces the capacitance in the device thus improving (reducing) the RC effect bandwidth limitation and consequently improving the photodiode gain-bandwidth product.

Based on the structure proposed by embodiments of the invention, the absorption layer may be formed at a thickness which is comparatively lower (for example about 0.18 µm) as compared to a thickness typically formed for an absorption layer in conventional APDs (for example 0.3 µm). This reduction contributes to reducing the transit time and to improve bandwidth.

The new solution provides improved bandwidth at low multiplication gains and higher gain-bandwidth product owing to the single carrier operation of the device structure: the electron velocity at overshoot is larger than the holes saturation velocity (about one order of magnitude). Herein, overshoot is understood to correspond to a transitory regime where carriers achieve a velocity that is higher than the equilibrium velocity or saturation velocity.

Using the conventional APD structure represented in figure 1, and for a given device area, in order to achieve wide bandwidth at low multiplication gains and high gain-bandwidth product, it is necessary to reduce carriers transit time using thin absorption layer 106 and thin avalanche multiplication active layer 103. However, if the thickness of the avalanche multiplication layer 103 is reduced to values below 0.1 µm, the maximum available gain will become degraded due to a combination of a reduced breakdown voltage (because a large electric field may not be reached as needed for impact ionization process) and high dark current due to carriers tunneling effect under high applied bias voltage (for the sake of clarity it is to be noted that the electric field in the absorption layer is kept low while it is large enough in the avalanche layer to generate carriers by impact ionization mechanism). Also, an AllnAs avalanche layer is usually chosen thin enough to improve the noise figure of the device, however this is achieved at the expense of generating a high capacitance in the device.

As regards transit time and multiplication gain characteristics with respect to a specific absorption layer thickness, for example 200 nm, experiments have shown that for a conventional APD 100 as described in relation to figure 1, the transit time may vary from values of about 9 ps for a multiplication gain of 1, to about 16.6 ps for a multiplication gain of 10.

In contrast, using a single carrier APD 200 as proposed herein (and described with reference to figure 2), it is observed by experimentation that for an absorption layer thickness of 200 nm, the transit time is improved by a factor of about 2 in comparison to a conventional APD 100 as described above. Exemplary values of such transit time are from values of about 2.8 ps for a multiplication gain of 1, to about 10 ps for a multiplication gain of 10. In addition, the insertion of a collector layer contributes to reducing device capacitance and thus to reducing the associated low-pass filter limitation therefore contributing to improve the overall device bandwidth at low gains and gain-bandwidth product. The APD obtained according to embodiments of the invention may be laterally illuminated or surface illuminated.

It is to be noted that the order of the steps of the method of the invention as described and recited in the corresponding claims is not limited to the order as presented and described and may vary without departing from the scope of the invention.

## Claims

1. An avalanche photodiode (200), comprising a p-doped absorption layer (213), an avalanche multiplication layer (203), and an n-doped collector layer (211), the collector layer being capable of collecting electrons injected from the avalanche layer and further configured to transfer electrons to a contact layer (202) provided at an opposite side of the collector layer with respect to a side where the avalanche layer (203) is positioned, the avalanche multiplication layer (203) being unintentionally doped and the p-doped absorption layer (213) being doped at about 5x10¹⁷ cm⁻³ or comprises a gradual p-doping level which varies between 5x10¹⁷ cm⁻³ and 2x10¹⁸ cm⁻³.

2. The avalanche photodiode of claim 1, further comprising a built-in field layer (212) of n+ doped material provided between the avalanche multiplication layer and the collection layer.

3. The avalanche photodiode according to any one of claims 1 or 2 wherein the p-doped absorption layer (213) is of InGaAs material or GaAsSb material.

4. The avalanche photodiode according to any one of claims 1 to 3 wherein the collector layer (211) is of GaInAsP material.

5. The avalanche photodiode according to any one of claims 2 to 4 wherein the built-in field layer (212) is of InAlAs material.

6. A method of manufacturing an avalanche photodiode comprising the steps of:
- generating a p-doped absorption layer (213),
- generating avalanche multiplication layer (203); generating an n-doped collector layer (211), the collector layer being capable of collecting electrons injected from the avalanche layer and further configured to transfer electrons to a contact layer (202) provided at an opposite side of the collector layer with respect to a side where the avalanche layer (203) is positioned;
the avalanche multiplication layer (203) being unintentionally doped and the step of generating a p-doped absorption layer comprises a doping of said absorption layer at about 5x10¹⁷ cm⁻³ or comprises a gradual p-doping level which varies between 5x10¹⁷ cm⁻³ and 2x10¹⁸ cm⁻³.

7. The method of claim 6 further comprising the step of generating a built-in field layer (212) of n+ doped material between the avalanche multiplication layer and the collection layer.

## Patentansprüche

1. Lawinenfotodiode (200), die eine p-dotierte Absorptionsschicht (213), eine Avalanchevervielfachungsschicht (203), und eine n-dotierte Kollektorschicht (211) enthält, wobei die Kollektorschicht in der Lage ist, Elektronen zu sammeln, die von der Avalancheschicht injiziert werden, und ferner dafür ausgelegt ist, Elektronen auf eine Kontaktschicht (202) zu übertragen, die an einer entgegengesetzten Seite der Kollektorschicht mit Bezug auf eine Seite vorgesehen ist, wo sich die Avalancheschicht (203) befindet, wobei die Avalanchevervielfachungsschicht (203) unabsichtlich dotiert ist und wobei die p-dotierte Absorptionsschicht (213) mit etwa 5x10¹⁷ cm⁻³ dotiert ist und einen progressiven p-Dotierungsgrad umfasst, der zwischen 5x10¹⁷ cm⁻³ und 2x10¹⁸ cm⁻³ variiert.

2. Lawinenfotodiode nach Anspruch 1, die ferner eine integrierte Feldschicht (212) von n+-dotiertem Material umfasst, die zwischen der Avalanchevervielfachungsschicht und der Sammelschicht vorgesehen ist.

3. Lawinenfotodiode nach einem der Ansprüche 1 oder 2, wobei die p-dotierte Absorptionsschicht (213) aus InGaAs-Material oder GaAsSb-Material ist.

4. Lawinenfotodiode nach einem der Ansprüche 1 bis 3, wobei die Kollektorschicht (211) aus GaInAsP-Material ist.

5. Lawinenfotodiode nach einem der Ansprüche 2 bis 4, wobei die integrierte Feldschicht (212) aus InAlAs-Material ist.

6. Verfahren zum Herstellen einer Lawinenfotodiode, das die folgenden Schritte umfasst:
- Erzeugen einer p-dotierten Absorptionsschicht (213),
- Erzeugen einer Avalanchevervielfachungsschicht (203);
- Erzeugen einer n-dotierten Kollektorschicht (211), wobei die Kollektorschicht in der Lage ist, Elektronen zusammen, die von der Avalancheschicht injiziert werden, und die ferner in der Lage ist, Elektronen auf eine Kontaktschicht (202) zu übertragen, die an einer entgegengesetzten Seite der Kollektorschicht mit Bezug auf eine Seite vorgesehen ist, wo die Avalancheschicht (203) positioniert ist;
wobei die Avalanchevervielfachungsschicht (203) unabsichtlich dotiert ist, und der Schritt des Erzeugens einer p-dotierten Absorptionsschicht umfasst eine Dotierung der Absorptionsschicht mit etwa 5x10¹⁷ cm⁻³ oder umfasst einen progressiven p-Dotierungspegel zwischen 5x10¹⁷ cm⁻³ und 2x10¹⁸ cm⁻³.

7. Verfahren nach Anspruch 6, das ferner den Schritt des Erzeugens einer integrierten Feldschicht (212) von n+-dotiertem Material zwischen der Avalanchevervielfachungsschicht und der Sammelschicht umfasst.

## Revendications

1. Photodiode à effet d'avalanche (200) comprenant une couche d'absorption dopée p (213), une couche de multiplication par avalanche (203) et une couche collectrice dopée n (211), la couche collectrice pouvant collecter des électrons injectés depuis la couche à effet d'avalanche et configurée en outre pour transférer des électrons à une couche de contact (202) disposée sur un côté opposé de la couche collectrice par rapport à un côté où la couche à effet d'avalanche (203) est positionnée, la couche de multiplication par avalanche (203) étant dopée de manière non intentionnelle et la couche d'absorption dopée p (213) étant dopée à environ 5 x 10¹⁷ cm⁻³ ou comprend un niveau de dopage p graduel qui varie entre 5 x 10¹⁷ cm⁻³ et 2 x 10¹⁸ cm⁻³.

2. Photodiode à effet d'avalanche selon la revendication 1, comprenant en outre une couche de champ intégrée (212) d'un matériau dopé n+ disposée entre la couche de multiplication par avalanche et la couche collectrice.

3. Photodiode à effet d'avalanche selon l'une quelconque des revendications 1 ou 2, dans laquelle la couche d'absorption dopée p (213) est composée d'un matériau InGaAs ou d'un matériau GaAsSb.

4. Photodiode à effet d'avalanche selon l'une quelconque des revendications 1 à 3, dans laquelle la couche collectrice (211) est composée d'un matériau GaInAsP.

5. Photodiode à effet d'avalanche selon l'une quelconque des revendications 2 à 4, dans laquelle la couche de champ intégrée (212) est composée d'un matériau InAIAs.

6. Procédé de fabrication d'une photodiode à effet d'avalanche comprenant les étapes suivantes :
- la génération d'une couche d'absorption dopée p (213),
- la génération d'une couche de multiplication par avalanche (203) ;
- la génération d'une couche collectrice dopée n (211), la couche collectrice pouvant collecter des électrons injectés depuis la couche à effet d'avalanche et configurée en outre pour transférer des électrons à une couche de contact (202) disposée sur un côté opposé de la couche collectrice par rapport à un côté où la couche à effet d'avalanche (203) est positionnée,
la couche de multiplication par avalanche (203) étant dopée de manière non intentionnelle et l'étape de génération d'une couche d'absorption dopée p comprend un dopage de ladite couche d'absorption à environ 5 x 10¹⁷ cm⁻³ ou comprend un niveau de dopage p graduel qui varie entre 5 x 10¹⁷ cm⁻³ et 2 x 10¹⁸ cm⁻³.

7. Procédé selon la revendication 6, comprenant en outre l'étape de génération d'une couche de champ intégrée (212) d'un matériau dopé n+ entre la couche de multiplication par avalanche et la couche collectrice.
